# EUROPEAN PATENT APPLICATION

(11) **EP 4 089 479 A1**
(43) Date of publication of application: **16.11.2022**
(21) Application number: 22171082.5
(22) Date of filing: 02.05.2022
(51) Int. Cl.: G03B 17/12, G03B 30/00, G02B 7/02, G03B 3/10

(54) **CAMERA MODULE WITH LENS TURRET**

(30) Priority: 12.05.2021 KR 20210061353
(71) Applicant: Power Logics Co., Ltd, Chungcheongbuk-do 28121 (KR)
(72) Inventor: SHIN, Doo-Sik, 13486 Gyeonggi-do (KR); CHO, Won-Man, 13486 Gyeonggi-do (KR); KIM, Young-Jin, 13486 Gyeonggi-do (KR); CHU, Ho-Seong, 13486 Gyeonggi-do (KR)
(74) Representative: Zacco Sweden AB

(57) **Abstract**

A camera module includes a first circuit board on which the image sensor is mounted; a plurality of lens barrels spaced apart from the first circuit board; a carrier on which the plurality of lens barrels are mounted and configured to move along a plane intersecting an optical axis so as to align any one of the plurality of the lens barrel with the image sensor; an actuator configured to move the carrier to each of an optical axis direction and a direction intersecting the optical axis direction; and a housing receiving therein at least a portion of each of the lens barrels and the actuator.

## Description

### BACKGROUND

### Field

The present disclosure relates to a camera module, and more particularly, to a camera module provided in a portable electronic device.

### Description of Related Art

Contents described in this Background section simply provide background information about the present disclosure and do not constitute the prior art.

A camera module for image data acquisition is used in more and more applications. For example, portable electronic devices such as smartphones and tablet PCs are equipped with a camera module, so that a user may easily take a required image.

As the camera module used is further improved, image quality thereof may be improved. Additional functions may be integrated into the camera module in some cases. Further, at the same time, a trend of miniaturization of the camera module is increasing.

In order for the camera module to take a clear image of an object, an auto-focusing function may be incorporated in the camera module.

In this regard, Korean Patent Application Publication No. 10-2011-0034852 as a prior art, discloses a camera module in which an auto-focusing function is implemented.

In one example, in order to satisfy the user's various needs, the camera module needs to have a plurality of lens barrels having different functions from each other.

For example, the plurality of lens barrels may include a lens barrel used to photograph a wide-angle image, a lens barrel used to photograph a zoomed-up image, and a general lens barrel used to photograph an object at an appropriate angle of view (AOV) and an appropriate size.

Further, for user convenience, it is necessary to easily align one of the plurality of lens barrels with an image sensor for a target photographing purpose.

However, a structure in which a necessary lens barrel among the plurality of lens barrels is aligned with the image sensor for a target photographing purpose is not disclosed in the prior art. Further, the prior art fails to disclose a structure in which the plurality of lens barrels are replaceable, and at the same time, an auto-focusing function is implemented.

Thus, there is a need to solve this prior art problem.

### SUMMARY

Accordingly, a purpose of the present disclosure is to provide a camera module having a structure in which a desired one of a plurality of lens barrels having different functions is aligned with an image sensor for a target photographing purpose.

Further, a purpose of the present disclosure is to provide a camera module having a structure in which both a function of aligning a necessary lens barrel among a plurality of lens barrels with an image sensor in an optical axis direction and an auto-focusing function are implemented.

Purposes of the present disclosure are not limited to the above-mentioned purpose. Other purposes and advantages of the present disclosure that are not mentioned may be understood based on following descriptions, and may be more clearly understood based on embodiments of the present disclosure. Further, it will be easily understood that the purposes and advantages of the present disclosure may be realized using means shown in the claims and combinations thereof.

A first aspect of the present disclosure provides a camera module comprising: an image sensor mounted on a first circuit board; a plurality of lens barrels spaced apart from the first circuit board, wherein the plurality of lens barrels are mounted on a carrier; the carrier configured to move along a plane intersecting an optical axis so as to align one of the plurality of the lens barrel with the image sensor; an actuator configured to move the carrier in each of the optical axis direction and a direction intersecting the optical axis; and a housing receiving therein at least a portion of each of the lens barrels and the actuator.

In one implementation of the first aspect, the carrier includes: a first cell configured to be rotatable around a rotation axis parallel to the optical axis, wherein the first cell has a first protrusion protruding therefrom in the direction intersecting the optical axis; and a second cell coupled to a distal end of the first protrusion, wherein the second cell has a hollow cylindrical shape such that the lens barrel is received therein.

In one implementation of the first aspect, the first protrusion includes a plurality first protrusions extending radially from a center of the first cell, wherein the second cell includes a plurality of second cells respectively coupled to distal ends of the first protrusions.

In one implementation of the first aspect, the camera module further comprises: a plurality of AF (auto-focusing) magnets respectively mounted on outer faces of the second cells for performing auto-focusing of the lenses of the lens barrels; and an AF sensor mounted on the housing to sense change in a position of each of the AF magnets.

In one implementation of the first aspect, the actuator includes: a yoke; a first driver mounted on the yoke; a first rotator mounted on the first driver and configured to rotate around a rotation axis parallel to the optical axis under operation of the first driver; a second driver mounted on the first rotator; and a second rotator mounted on the second driver and configured to rotate around a rotation axis parallel to the optical axis under operation of the second driver.

In one implementation of the first aspect, the first driver includes: a first piezoelectrically driving portion made of a piezoelectric material and mounted on the yoke; and a first gear structure configured to contact the first piezoelectrically driving portion and formed in a ring shape, wherein the first gear structure has gear teeth formed on one face thereof, wherein under an operation of the first piezoelectrically driving portion, the first gear structure is deformed sequentially in a circumferential direction thereof so as to generate a wave sequentially in the circumferential direction thereof.

In one implementation of the first aspect, the actuator further includes a plurality of coupling magnets arranged in a circumferential direction of the first rotator, and extending through the first rotator, wherein the plurality of coupling magnets allow the first rotator to closely contact the first driver, and allow the second rotator to closely contact the second driver.

In one implementation of the first aspect, the first rotator includes a guide portion formed on an outer edge thereof, wherein the first cell includes: a second protrusion protruding therefrom in the direction intersecting the optical axis; and a guide pin protruding in the first direction from a distal end of the second protrusion so as to be inserted into the guide portion.

In one implementation of the first aspect, the guide pin is inserted into the guide portion such that the carrier is engaged with the first rotator and rotates together with the rotation of the first rotator.

In one implementation of the first aspect, the first cell further includes a third protrusion protruding from a rotating center portion thereof in the first direction, wherein a thread is formed on an outer face of the third protrusion, wherein the second rotator has a hollow portion, wherein a thread is formed on an inner face of the hollow portion such that the thread of the hollow portion is meshed with the thread of the third protrusion.

In one implementation of the first aspect, the carrier is screw-coupled to the second rotator via the meshed threads such that as the second rotator rotates, the carrier is configured to move in the first direction for auto-focusing of the lens.

In one implementation of the first aspect, the second driver includes: a second piezoelectrically driving portion made of a piezoelectric material and mounted on the first rotator; and a second gear structure configured to contact the second piezoelectrically driving portion and formed in a ring shape, wherein the second gear structure has gear teeth formed on one face thereof, wherein under an operation of the second piezoelectrically driving portion, the second gear structure is deformed sequentially in a circumferential direction thereof so as to generate a wave sequentially in the circumferential direction thereof.

In one implementation of the first aspect, the second piezoelectrically driving portion is configured to rotate together with the rotation of the first rotator, wherein a connective cable is electrically connected to the second piezoelectrically driving portion and has a predetermined length and is made of a flexible material so as not to interfere with the rotation of the second piezoelectrically driving portion.

In one implementation of the first aspect, the actuator further includes: a first magnet mounted on the first rotator; and a first sensor mounted on the yoke and configured to sense change in a position of the first magnet and sense at least one of a rotation direction or a rotation angle of the first rotator based on the change.

In one implementation of the first aspect, the image sensor and the plurality of the lens barrel are disposed at positions spaced apart from a center of the housing in a radial direction of the housing, wherein the carrier is configured to be rotatable around the rotation axis such that one of the plurality of the lens barrel is aligned with the image sensor in the optical axis direction.

A second aspect of the present disclosure provides a camera module comprising: an image sensor; a plurality of lens barrels spaced apart from the image sensor, wherein the plurality of lens barrels are mounted on a carrier; the carrier configured to move along a plane intersecting an optical axis so as to align one of the plurality of the lens barrel with the image sensor; an actuator configured to move the carrier in each of the optical axis direction and a direction intersecting the optical axis; a housing receiving therein at least a portion of each of the lens barrels and the actuator; and a shield can mounted on the housing and shielding electromagnetic interference.

In one implementation of the second aspect, the camera module further comprises an infrared blocking filter disposed between the image sensor and the actuator.

In one implementation of the second aspect, the actuator includes: a yoke; a first driver mounted on the yoke; a first rotator mounted on the first driver and configured to rotate around a rotation axis parallel to the optical axis under operation of the first driver; a second driver mounted on the first rotator; and a second rotator mounted on the second driver and configured to rotate around a rotation axis parallel to the optical axis under operation of the second driver.

In one implementation of the second aspect, the first driver includes: a first piezoelectrically driving portion made of a piezoelectric material and mounted on the yoke; and a first gear structure configured to contact the first piezoelectrically driving portion and formed in a ring shape, wherein the first gear structure has gear teeth formed on one face thereof, wherein under an operation of the first piezoelectrically driving portion, the first gear structure is deformed sequentially in a circumferential direction thereof so as to generate a wave sequentially in the circumferential direction thereof.

In one implementation of the second aspect, the second driver includes: a second piezoelectrically driving portion made of a piezoelectric material and mounted on the first rotator; and a second gear structure configured to contact the second piezoelectrically driving portion and formed in a ring shape, wherein the second gear structure has gear teeth formed on one face thereof, wherein under an operation of the second piezoelectrically driving portion, the second gear structure is deformed sequentially in a circumferential direction thereof so as to generate a wave sequentially in the circumferential direction thereof.

In the camera module according to the present disclosure, rotating the first rotator may allow one of the plurality of lens barrels at positions to be aligned with the image sensor in the optical axis direction.

Further, in the camera module according to the present disclosure, controlling the operation of the first driver and the second driver may achieve both the operation of the auto-focusing and the operation of aligning a necessary lens barrel among the plurality of lens barrels with the image sensor in the optical axis direction.

The effect of the present disclosure is not limited to the above-mentioned effects, and another effect not mentioned will be clearly understood by those skilled in the art from the following descriptions.

The purposes, the solutions, and the effects as described above do not specify essential characteristics of the claims, and thus may not limit the scope of the present disclosure.

### BRIEF DESCRIPTION OF DRAWINGS

FIG. 1 is a perspective view showing a camera module according to an embodiment.
FIG. 2 is a diagram of a state in which a shield can is omitted from FIG. 1.
FIG. 3 is an exploded perspective view showing a camera module according to an embodiment.
FIG. 4 is a perspective view showing a carrier according to an embodiment.
FIG. 5 is a view of FIG. 4 viewed in a different direction.
FIG. 6 is an exploded perspective view showing an actuator according to an embodiment.
FIG. 7 is a cross-sectional view showing a portion of a camera module according to an embodiment.
FIG. 8 is a cross-sectional view of a state in which some components of a camera module are omitted according to an embodiment.

### DETAILED DESCRIPTIONS

The above-described aspects, features and advantages are specifically described hereunder with reference to the accompanying drawings such that one having ordinary skill in the art to which the present disclosure pertains can embody the technical spirit of the disclosure easily. In the disclosure, detailed description of known technologies in relation to the disclosure is omitted if it is deemed to make the gist of the disclosure unnecessarily vague. Below, preferred embodiments according to the disclosure are specifically described with reference to the accompanying drawings. In the drawings, identical reference numerals can denote identical or similar components.

The terms "first", "second" and the like are used herein only to distinguish one component from another component. Thus, the components should not be limited by the terms. Certainly, a first component can be a second component unless stated to the contrary.

Throughout the disclosure, each component can be provided as a single one or a plurality of ones, unless explicitly stated to the contrary.

The singular forms "a", "an" and "the" are intended to include the plural forms as well, unless explicitly indicated otherwise. It should be further understood that the terms "comprise" or "include" and the like, set forth herein, are not interpreted as necessarily including all the stated components or steps but can be interpreted as excluding some of the stated components or steps or can be interpreted as including additional components or steps.

Throughout the disclosure, the terms "A and/or B" as used herein can denote A, B or A and B, and the terms "C to D" can denote C or greater and D or less, unless stated to the contrary.

As used herein, an optical axis refers to a propagation direction of light passing through a lens.

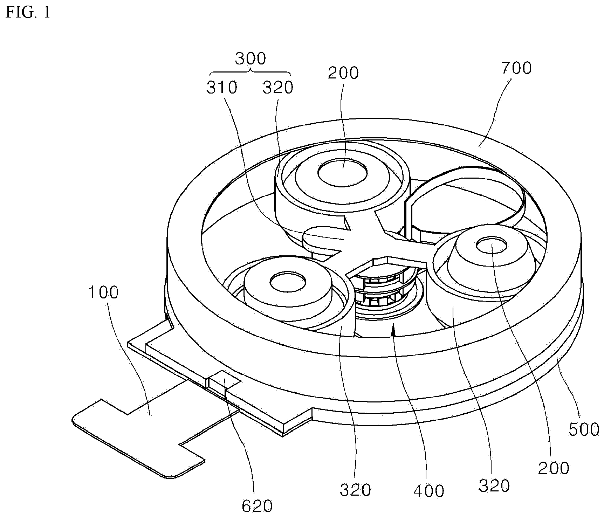

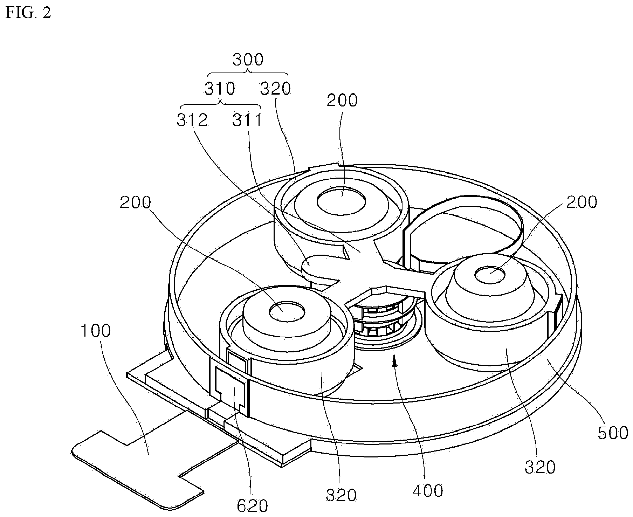

FIG. 1 is a perspective view showing a camera module according to an embodiment. FIG. 2 is a view of a state in which a shield can 700 is omitted from FIG. 1.

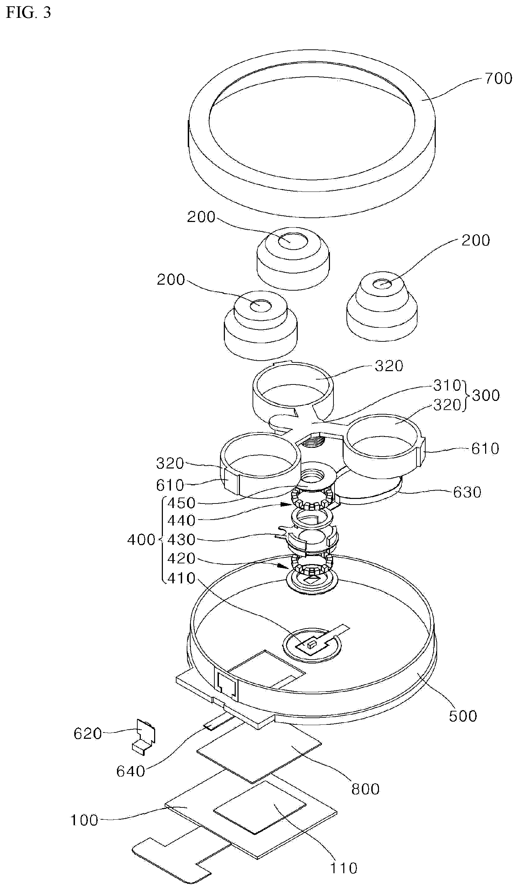

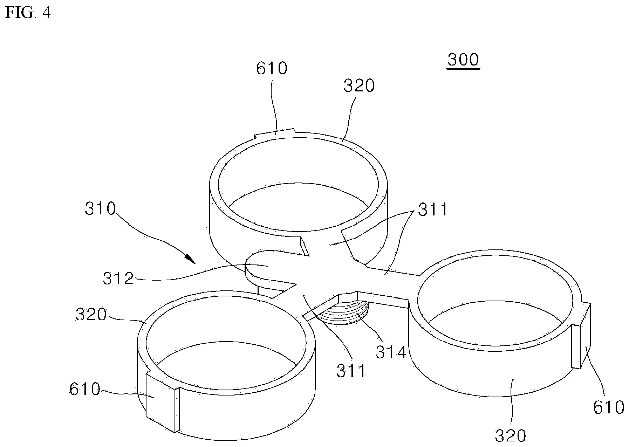

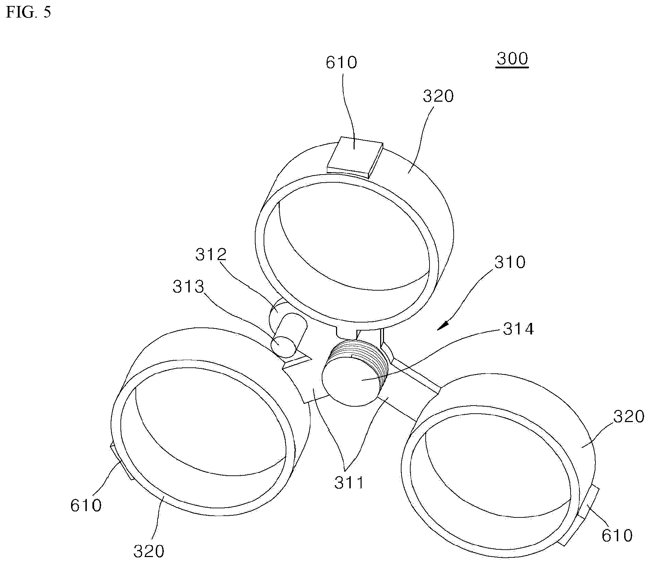

FIG. 3 is an exploded perspective view showing a camera module according to an embodiment. FIG. 4 is a perspective view showing a carrier 300 according to an embodiment. FIG. 5 is a view of FIG. 4 viewed in a different direction.

A camera module according to an embodiment may include a first circuit board 100, a lens barrel 200, a carrier 300, an actuator 400, a housing 500, and the shield can 700.

An image sensor 110 may be mounted on the first circuit board 100. The first circuit board 100 may constitute a bottom of the camera module, and the image sensor 110 mounted thereon may detect an image of an object in response to light passing through a lens.

The lens barrel 200 may include a plurality of lens barrels 200 and may be disposed to be spaced apart from the first circuit board 100. Accordingly, the lens barrel 200 may be disposed to be spaced apart from the image sensor 110 mounted on the first circuit board 100.

The lens barrel 200 may constitute a front portion of the camera module. The lens barrel 200 may include a lens array in which at least one lens of a concave lens, a convex lens, and a planar lens is arranged in a plural manner. The lens array may be configured such that a plurality of lenses are arranged in an optical axis direction, that is, a direction in which the lens barrel 200 faces toward the image sensor 110.

The plurality of lens barrels 200 according to an embodiment may include, for example, a lens barrel 200 used to photograph a wide-angle image, a lens barrel 200 used to photograph a zoomed-up image, and a general lens barrel 200 used for photographing an object at an appropriate angle of view (AOV) and an appropriate size.

The carrier 300 may have the lens barrel 200 mounted thereon, and may move on a plane intersecting the optical axis to align one of the plurality of lens barrels 200 with the image sensor 110. In this regard, the alignment of the lens barrel 200 and the image sensor 110 means that the lens barrel 200 and the image senor 110 overlap each other in the optical axis direction.

The image sensor 110 and the plurality of the lens barrel 200 may be disposed at positions spaced apart from a center of the housing 500 in a radial direction of the housing 500. The carrier 300 may be rotatable on a plane intersecting the optical axis so that one of the plurality of lens barrels 200 is aligned with the image sensor 110 in the optical axis direction.

The actuator 400 may move the carrier 300 in the optical axis direction and a direction intersecting the optical axis direction. The actuator 400 may move the carrier 300 on which the lens barrel 200 has been mounted in the optical axis direction for the auto-focusing function.

Further, the actuator 400 may, for example, rotate one of the lens barrels 200 having different functions in the direction intersecting the optical axis direction to align said one of the lens barrels 200 with the image sensor 110 in the optical axis direction.

The housing 500 may house at least a portion of each of the lens barrel 200 and the actuator 400. The housing 500 may have a bottom plate and a side plate formed to have a ring shape and extending upwardly from an edge of the bottom plate, and may accommodate at least a portion of each of the lens barrel 200 and the actuator 400 in a space defined by the bottom plate and the side plate.

The lens barrel 200 and the image sensor 110 may be disposed on front and rear portions of the bottom plate of the housing 500, respectively. Accordingly, a through hole may be formed in the bottom plate of the housing 500 at a position where the image sensor 110 and the lens barrel 200 overlap with each other in the optical axis direction so that light passing through the lens barrel 200 may reach the image sensor 110.

The shield can 700 may be mounted on the housing 500, and may shield electromagnetic interference. The shield can 700 may be provided in a ring shape so as to be fitted to the side plate of the housing 500, and may have a bent portion.

The shield can 700 may be made of a material that effectively shields electromagnetic wave interference, for example, a metal material.

The camera module according to an embodiment may further include an infrared blocking filter 800. The infrared blocking filter 800 may be disposed between the image sensor 110 and the actuator 400, and may block at least a portion of infrared ray included in light incident on the image sensor 110 through the lens barrel 200. This may increase quality of an image detected by the image sensor 110.

The carrier 300 may include a first cell 310 and a second cell 320.

The first cell 310 may be configured to be rotatable, and a rotation axis thereof may be oriented in a direction parallel to the optical axis. The first cell 310 may include a first protrusion 311 protruding in a direction intersecting the optical axis.

The second cell 320 may be coupled to an end of the first protrusion 311 and may be provided in a hollow cylindrical shape so that the lens barrel 200 may be mounted therein.

The first cell 310 may rotate along a plane intersecting the optical axis under operation of the actuator 400. Accordingly, the second cell 320 coupled to the end of the first protrusion 311 of the first cell 310 may rotate, and thus, the plurality of lens barrels 200 respectively mounted in the second cells 320 may rotates along the plane intersecting the optical axis.

The first protrusion 311 may include a plurality of first protrusions extending radially from the first cell 310 and arranged to be spaced from each other by an angular spacing. The second cell 320 may include a plurality of second cells which are respectively coupled to distal ends of the plurality of first protrusions 311. Accordingly, the number of the first protrusions 311 and the number of the second cells 320 may be same as each other.

In the camera module of an embodiment, three the first cells 310 and the second cells 320 are provided. Accordingly, three lens barrels 200 having different functions are mounted in the three second cells. However, the present disclosure is not limited thereto. Each of the numbers of the second cells 320, and the lens barrels 200 may be two or four or larger.

The camera module according to an embodiment may further include an AF (auto-focusing) magnet 610 and an AF sensor 620.

The AF magnets 610 may be respectively mounted on outer faces of the plurality of the second cells 320, and may be provided for auto-focusing of the lens barrel 200. In one example, the AF magnet 610 may be embodied as a permanent magnet.

The AF sensor 620 may be mounted on the housing 500 and sense change in a position of the AF magnet 610. In one example, the AF sensor 620 may be embodied as a Hall sensor.

When the second cell 320 and the lens barrel 200 move in the optical axis direction under the operation of the actuator 400, the AF magnet 610 together therewith may move in the optical axis direction. The AF sensor 620 may sense the change in the position of the AF magnet 610 based on a detecting result of change in a magnetic field generated from the AF magnet 610 due to the movement of the AF magnet 610.

In the camera module of an embodiment, the auto-focusing may be performed using the AF magnet 610 and the AF sensor 620. The autofocusing may be performed by a controller controlling the AF sensor 620. The controller may be provided in a device to which the camera module is mounted, for example, a smartphone or a tablet PC.

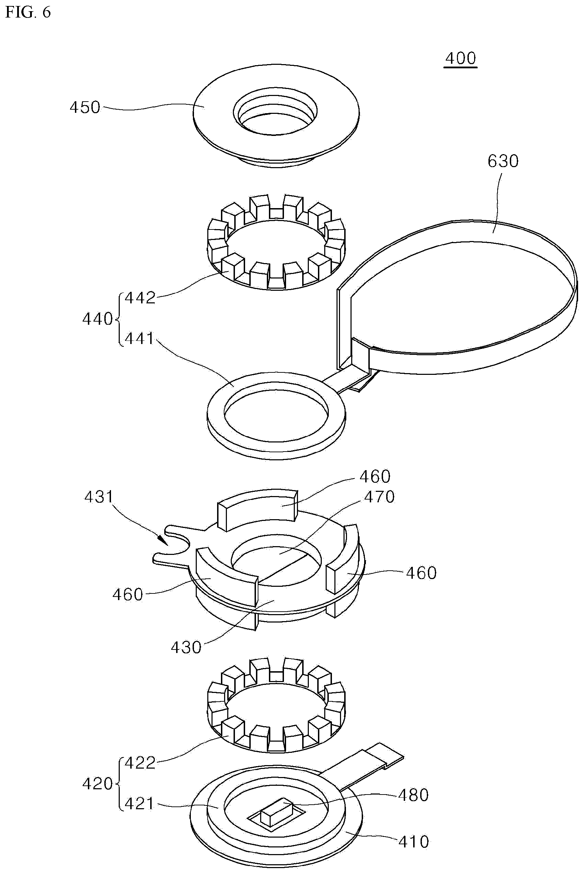

FIG. 6 is an exploded perspective view showing the actuator 400 according to an embodiment.

As shown in FIG. 6, the actuator 400 may include a yoke 410, a first driver 420, a first rotator 430, a second driver 440 and a second rotator 450.

The first driver 420 may be mounted on the yoke 410 which may support other components of the actuator 400. In this regard, the yoke 410 may be mounted on the bottom plate of the housing 500.

The first driver 420 may be mounted on the yoke 410 and cause the first rotator 430 to rotate along a plane intersecting the optical axis direction. The first driver 420 may receive electricity from the first circuit board 100 and receive a control signal therefrom.

Accordingly, the camera module may include a terminal 640 for electrical connection between the first driver 420 and the first circuit board 100.

The first rotator 430 may be mounted on the first driver 420, and may be rotated by the first driver 420 around the optical axis as a rotation axis. As the first rotator 430 rotates, the carrier 300 and the lens barrel 200 may rotate together therewith. An operation of the first rotator 430 is described in more detail below.

Accordingly, the first rotator 430 may rotate to align any one of the plurality of lens barrels 200 with the image sensor 110 in the optical axis direction, such that a lens used for a desired photographing purpose may be easily aligned with the image sensor.

The second driver 440 may be mounted on the first rotator 430 and may cause the second rotator 450 to rotate along a plane intersecting the optical axis direction. The second driver 440 may receive electricity from the first circuit board 100 and receive a control signal therefrom.

Accordingly, the camera module may include a connective cable 630 for electrical connection between the second driver 440 and the first circuit board 100.

The second rotator 450 may be mounted on the second driver 440 and may be rotated by the second driver 440 around the optical axis as a rotation axis. Under the rotation of the second rotator 450, the carrier 300 and the lens barrel 200 move in the optical axis direction to implement the auto-focusing. An operation of the second rotator 450 is described in more detail below.

The first driver 420 may include a first piezoelectrically driving portion 421 and a first gear structure 422.

The first piezoelectrically driving portion 421 may be made of a piezoelectricity material and mounted on the yoke 410. The piezoelectric material may change a volume and a shape thereof when electricity is input thereto. In an embodiment, the first piezoelectrically driving portion 421 may be deformed based on electricity input thereto from the first circuit board 100.

For example, the first piezoelectrically driving portion 421 may be formed in a ring shape, and may be divided into a plurality of sectors in a circumferential direction. When electricity is sequentially applied to the sectors along the circumferential direction, the first piezoelectrically driving portion 421 may be sequentially deformed in the circumferential direction such a wave may be sequentially generated.

The first gear structure 422 may be configured to contact the first piezoelectrically driving portion 421 and may be formed in a ring shape, and one face thereof may be formed in a gear manner. In this regard, a face of the first gear structure 422 in contact with the first piezoelectrically driving portion 421 may have a flat face, and an opposite face thereof in contact with the first rotator 430 may have gear teeth.

In an embodiment, each of the first piezoelectrically driving portion 421 and the first gear structure 422 may be formed in a ring shape while first piezoelectrically driving portion 421 and the first gear structure 422 correspond to each other. Further, the first gear structure 422 may be made of a material that is easily deformable. Accordingly, when the first piezoelectrically driving portion 421 receives electricity and thus operates, the wave may be sequentially generated the circumferential direction and then may be applied to the first gear structure 422 such that the first gear structure may be sequentially deformed in the circumferential direction.

When the first piezoelectrically driving portion 421 operates, the first gear structure 422 may be deformed in an integral manner with the deformation of the first piezoelectrically driving portion 421. In this regard, the gear teeth formed in the first gear structure 422 may be deformed while the wave is generated the circumferential direction and in a clockwise or counterclockwise direction.

Therefore, the first rotator 430 in contact with the face having the gear teeth of the first gear structure 422 may rotate clockwise or counterclockwise while the gear teeth of the first gear structure 422 are deformed sequentially in the wave manner clockwise or counterclockwise. In this regard, a force that rotates the first rotator 430 may be a friction force exerted by the gear teeth of the first gear structure 422 against the first rotator 430.

Hereinafter, the second driver 440 which has a structure similar to that of the first driver 420 will be described first. The second driver 440 may include a second piezoelectrically driving portion 441 and a second gear structure 442.

The second piezoelectrically driving portion 441 may be made of a piezoelectric material and mounted on the first rotator 430. For example, the second piezoelectrically driving portion 441 may be formed in a ring shape, and may be divided into a plurality of sectors in the circumferential direction. When electricity is sequentially applied to the sectors in the circumferential direction, the second piezoelectrically driving portion 441 may be deformed sequentially in the circumferential direction such that a wave may be generated sequentially along the sectors in the circumferential direction.

The second gear structure 442 may be configured to be in contact with the second piezoelectrically driving portion 441 and be formed in a ring shape, and one face thereof may have gear teeth.

In this regard, a face of the second gear structure 442 in contact with the second piezoelectrically driving portion 441 may have a flat face, and the opposite face thereof in contact with the second rotator 450 may have gear teeth.

In an embodiment, the second piezoelectrically driving portion 441 and the second gear structure 442 may be formed in a ring shape in a corresponding manner to each other.

Further, the second gear structure 442 may be made of a material that is easily deformable. Accordingly, when the second piezoelectrically driving portion 441 receives electricity and thus operates, the second gear structure 442 may be deformed sequentially in the circumferential direction such that the wave may be generated in sequentially along the gear teeth in the circumferential direction.

When the second piezoelectrically driving portion 441 operates, the second gear structure 442 may be deformed in an integral manner with the deformation of the second piezoelectrically driving portion 441. In this regard, the gear teeth formed in the second gear structure 442 may be deformed sequentially in the circumferential direction in a clockwise or counterclockwise direction.

Therefore, the second rotator 450 in contact with the gear teeth of the second gear structure 442 may rotate clockwise or counterclockwise while the gear teeth of the second gear structure 442 are deformed sequentially in the circumferential direction in a clockwise or counterclockwise direction. In this regard, a force that rotates the second rotator 450 may be a friction force exerted by the gear teeth of the second gear structure 442 against the second rotator 450.

The actuator 400 may further include a plurality of coupling magnets 460. The coupling magnets 460 may extend through the first rotator 430 and may be arranged in a circumferential direction of the first rotator 430. Accordingly, the first rotator 430 may have a through hole defined therein in which each of the coupling magnet 460 is inserted and mounted.

The coupling magnet 460 may serve to allow the first rotator 430 to closely contact the first driver 420 and to allow the second rotator 450 to closely contact the second driver 440. Although three coupling magnets 460 are used in the embodiment, there is no particular limitation on the number of coupling magnets 460.

Referring to FIG. 6, the coupling magnet 460 may allow the first piezoelectrically driving portion 421, the first gear structure 422, the first rotator 430, the second piezoelectrically driving portion 441, and the second rotator 450 to closely contact each other. In order to maintain this close contact, for example, the second rotator 450 may be made of a metal material magnetically attracted to the magnet.

Further, in order to stably keep these components in close contact with each other, the coupling magnet 460 may have a larger dimension in the optical axis direction than a dimension of the first rotator 430 in the optical axis direction.

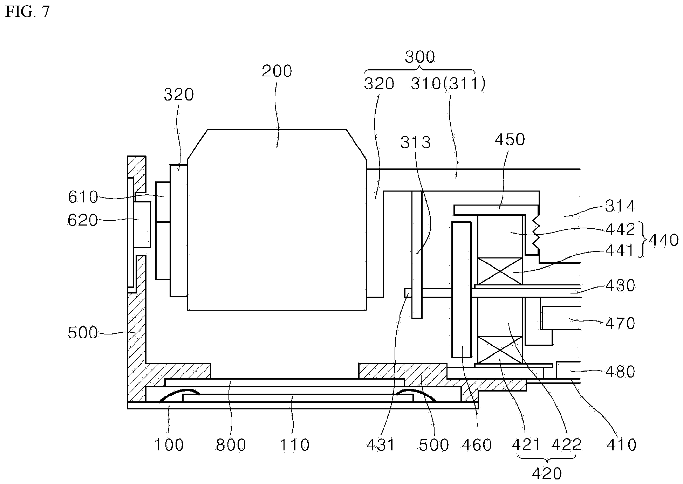

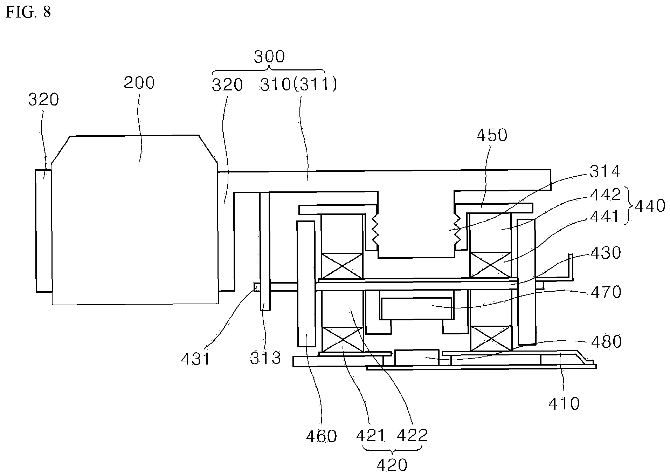

FIG. 7 is a cross-sectional view showing a portion of a camera module according to an embodiment. FIG. 8 is a cross-sectional view of a state in which some components of the camera module are omitted according to an embodiment.

The first rotator 430 may include a guide portion 431 formed on an outer edge thereof. The guide portion 431 may include a portion protruding from an outer face of the first rotator 430 and a hole defined in the protruding portion into which a guide pin 313 is inserted.

In one example, the first cell 310 includes a second protrusion 312 protruding in a direction intersecting the optical axis, and the guide pin 313 protruding downwardly in a direction parallel to the optical axis from an end of the second protrusion 312 and inserted into the hole of the guide portion 431.

As the guide pin 313 is inserted into the hole of the guide portion 431, the carrier 300 is engaged with the first rotator 430 and rotates together with the rotation of the first rotator 430.

That is, since the guide pin 313 of the first cell 310 is inserted into the hole of the guide portion 431 of the first rotator 430, the carrier 300 may rotate together with the rotation of the first rotator 430. Therefore, as the first rotator 430 rotates, the carrier 300 and the lens barrel 200 rotate together. Thus, a rotation direction and a rotation angle of the first rotator 430 may be controlled such that the necessary lens barrel 200 among the plurality of lens barrel 200 may be aligned with the image sensor 110 in the optical axis direction.

The first cell 310 may further include a third protrusion 314 protruding from a rotating central portion in a direction parallel to the optical axis and having a screw thread formed thereon. Further, the second rotator 450 may be configured to have a hollow having a thread formed on an inner face thereof so as to be screw-coupled to the third protrusion 314.

In this regard, in order for the carrier 300 and the second rotator 450 to move smoothly with respect to each other, a sufficient clearance may be defined between the thread portion of the carrier 300 and the thread portion of the second rotator 450.

The carrier 300 may be screw-coupled to the second rotator 450. Thus, as the second rotator 450 rotates, the carrier 300 may move in a direction parallel to the optical axis for auto-focusing.

As described above, the guide pin 313 may be coupled to the guide portion 431, such that the carrier 300 may be engaged with the first rotator 430 and may rotate with the rotation of the first rotator. Therefore, when the first rotator 430 does not rotate, the carrier 300 does not rotate.

When the second rotator 450 rotates while the first rotator 430 does not rotate, the carrier 300 does not rotate, but the carrier 300 moves in the direction parallel to the optical axis due to the screw coupling structure between the carrier 300 and the second rotator 450, thereby allowing the lens barrel 200 mounted in the carrier 300 to perform the auto-focus function.

According to the above structure, the second piezoelectrically driving portion 441 may be configured to rotate together with the rotation of the first rotator 430. Therefore, the connective cable 630 for connecting the first circuit board 100 and the second piezoelectrically driving portion 441 to each other needs to be constructed not to be damaged under the rotation of the second piezoelectrically driving portion 441 or not to interfere with the rotation of the second piezoelectrically driving portion 441.

Accordingly, the connective cable 630 electrically connected to the second piezoelectrically driving portion 441 may have a predetermined length not to interfere with the rotation of the second piezoelectrically driving portion 441 and be made of a flexible material.

The actuator 400 may further include a first magnet 470 and a first sensor 480. The first magnet 470 may be mounted on the first rotator 430. The first magnet 470 may be embodied as a permanent magnet by way of example.

The first sensor 480 may be mounted on the yoke 410 and may detect change in the position of the first magnet 470 to detect at least one of a rotation direction or a rotation angle of the first rotator 430. The first sensor 480 may be, for example, a Hall sensor.

For example, the first sensor 480 may be mounted on a central portion of the yoke 410, and the first magnet 470 may be mounted at a position of the first rotator 430 facing the first sensor 480 in the optical axis direction.

The first magnet 470 may rotate as the first rotator 430 rotates. Therefore, when the rotation direction and the rotation angle of the first magnet 470 are identified, the rotation direction and the angle of the first rotator 430 may be identified.

The first sensor 480 detects the change in the magnetic field generated under the rotation of the first magnet 470 and may detect at least one of the rotation direction or the rotation angle of the first rotator 430 based on the change.

The controller for controlling the operation of the camera module may receive information about the rotation direction and the rotation angle of the first rotator 430 from the first sensor 480 and control the rotation operation of the first rotator 430 based on the received information.

In an embodiment, the controller may control operations of the first driver 420 and the second driver 440 such that both the auto-focusing operation and the aligning operation of the necessary lens barrel 200 among the plurality of lens barrel 200 with the image sensor 110 in the optical axis direction may be effectively performed.

The embodiments are described above with reference to a number of illustrative embodiments thereof. However, embodiments are not limited to the embodiments and drawings set forth herein, and numerous other modifications and embodiments can be devised by one skilled in the art within the technical scope of the disclosure. Further, the effects and predictable effects based on the configurations in the disclosure are to be included within the range of the disclosure though not explicitly described in the description of the embodiments.

## Claims

1. A camera module comprising:
a first circuit board on which a image sensor is mounted;
a plurality of lens barrels spaced apart from the first circuit board;
a carrier on which the plurality of lens barrels are mounted and configured to move along a plane intersecting an optical axis so as to align any one of the plurality of lens barrel with the image sensor;
an actuator configured to move the carrier to each of an optical axis direction and a direction intersecting the optical axis; and
a housing receiving therein at least a portion of each of the lens barrels and the actuator.

2. The camera module of claim 1, wherein the carrier includes:
a first cell configured to be rotatable around a rotation axis parallel to the optical axis, wherein the first cell has a first protrusion protruding therefrom in the direction intersecting the optical axis; and
a second cell coupled to a distal end of the first protrusion, wherein the second cell has a hollow cylindrical shape such that the lens barrel is received therein.

3. The camera module of claim 2, wherein the first protrusion includes a plurality of first protrusions extending radially from a center of the first cell,
wherein the second cell includes a plurality of second cells respectively coupled to distal ends of the first protrusions.

4. The camera module of claim 3, wherein the camera module further comprises:
a plurality of AF (auto-focusing) magnets respectively mounted on outer faces of the second cells for performing auto-focusing of the lenses of the lens barrels; and
an AF sensor mounted on the housing to sense change in a position of each of the AF magnets.

5. The camera module of claim 2, wherein the actuator includes:
a yoke;
a first driver mounted on the yoke;
a first rotator mounted on the first driver and configured to rotate around a rotation axis parallel to the optical axis under operation of the first driver;
a second driver mounted on the first rotator; and
a second rotator mounted on the second driver and configured to rotate around a rotation axis parallel to the optical axis under operation of the second driver.

6. The camera module of claim 5, wherein the first driver includes:
a first piezoelectrically driving portion made of a piezoelectric material and mounted on the yoke; and
a first gear structure configured to contact the first piezoelectrically driving portion and formed in a ring shape, wherein the first gear structure has gear teeth formed on one face thereof, wherein under an operation of the first piezoelectrically driving portion, the first gear structure is deformed sequentially in a circumferential direction thereof so as to generate a wave sequentially in the circumferential direction thereof.

7. The camera module of claim 5, wherein the actuator further includes a plurality of coupling magnets arranged in a circumferential direction of the first rotator, and extending through the first rotator, wherein the plurality of coupling magnets allow the first rotator to closely contact the first driver, and allow the second rotator to closely contact the second driver.

8. The camera module of claim 5, wherein the first rotator includes a guide portion formed on an outer edge thereof,
wherein the first cell includes:
a second protrusion protruding therefrom in the direction intersecting the optical axis; and
a guide pin protruding in the first direction from a distal end of the second protrusion so as to be inserted into the guide portion.

9. The camera module of claim 8, wherein the guide pin is inserted into the guide portion such that the carrier is engaged with the first rotator and rotates together with the rotation of the first rotator.

10. The camera module of claim 8, wherein the first cell further includes a third protrusion protruding from a rotating center portion thereof in the first direction, wherein a thread is formed on an outer face of the third protrusion,
wherein the second rotator has a hollow portion, wherein a thread is formed on an inner face of the hollow portion such that the thread of the hollow portion is meshed with the thread of the third protrusion.

11. The camera module of claim 10, wherein the carrier is screw-coupled to the second rotator via the meshed threads such that as the second rotator rotates, the carrier is configured to move in the first direction for auto-focusing of the lens.

12. The camera module of claim 5, wherein the second driver includes:
a second piezoelectrically driving portion made of a piezoelectric material and mounted on the first rotator; and
a second gear structure configured to contact the second piezoelectrically driving portion and formed in a ring shape, wherein the second gear structure has gear teeth formed on one face thereof, wherein under an operation of the second piezoelectrically driving portion, the second gear structure is deformed sequentially in a circumferential direction thereof so as to generate a wave sequentially in the circumferential direction thereof.

13. The camera module of claim 12, wherein the second piezoelectrically driving portion is configured to rotate together with the rotation of the first rotator,
wherein a connective cable is electrically connected to the second piezoelectrically driving portion and has a predetermined length and is made of a flexible material so as not to interfere with the rotation of the second piezoelectrically driving portion.

14. The camera module of claim 5, wherein the actuator further includes:
a first magnet mounted on the first rotator; and
a first sensor mounted on the yoke and configured to sense change in a position of the first magnet and sense at least one of a rotation direction or a rotation angle of the first rotator based on the change.

15. The camera module of claim 1, wherein the image sensor and the plurality of the lens barrel are disposed at positions spaced apart from a center of the housing in a radial direction of the housing,
wherein the carrier is configured to be rotatable around the rotation axis such that one of the plurality of the lens barrel is aligned with the image sensor in the optical axis direction.
